(19)

Europäisches Patentamt

European Patent Office

Office européen des brevets

(11) **EP 4 531 073 A2**

(12) **EUROPEAN PATENT APPLICATION**

(43) Date of publication:
**02.04.2025   Bulletin 2025/14**

(21) Application number: **24202622.7**

(22) Date of filing: **25.09.2024**

(51) International Patent Classification (IPC):
**H01J 37/304** (2006.01)

(52) Cooperative Patent Classification (CPC):
**H01J 37/3045**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **27.09.2023   DE 102023126288**

(71) Applicant: **Carl Zeiss SMT GmbH**
**73447 Oberkochen (DE)**

(72) Inventors:
• **KORB, Thomas**
**73447 Oberkochen (DE)**
• **KIM, Hyun Hwa**
**73447 Oberkochen (DE)**
• **KLOCHKOV, Dmitry**
**73447 Oberkochen (DE)**

(74) Representative: **Kraus & Lederer PartGmbB**
**Thomas-Wimmer-Ring 15**
**80539 München (DE)**

(54) **BEAM ANGLE ROTATION AND SAMPLE ROTATION**

(57)     The application relates to a method for operating an ion beam device, wherein a incidence angle $\alpha$ is determined at which an ion beam of the ion beam device hits an upper top surface of a semiconductor sample (20), and a rotation angle $\gamma$ for the semiconductor sample (20) around a rotation axis extending perpendicular to the upper top surface (24). The semiconductor sample (20) is rotated around the rotation axis with the determined rotation angle $\gamma$, and a scan angle O is determined between an adapted scan line along which the ion beam is moved when hitting the upper top surface (24), and a default scan line of the ion beam extending parallel to the upper top surface of the semiconductor sample, wherein the scan angle O is determined based on the determined rotation angle $\gamma$ and the incidence angle $\alpha$. The scan line is adapted to the amended scan line based on the determined scan angle O.

FIG 3

**Description**

CROSS-REFERENCE TO RELATED APPLICATION

Reference is made to commonly-assigned German patent application No. 10 2023 126 288.2, filed September 27, 2023, the entire disclosure of which hereby is incorporated by reference for all purposes.

TECHNICAL FIELD

The disclosure relates to a method for operating an ion beam device and to the corresponding ion beam device.

BACKGROUND

Semiconductor structures are amongst the finest man-made structures and suffer from different imperfections. Devices for quantitative 3D-metrology, defect-detection or defect review are looking for these imperfections. Fabricated semiconductor structures are based on prior knowledge. The semiconductor structures are manufactured from a sequence of layers being parallel to a substrate. For example, in a logic type sample, metal lines are running parallel in metal layers or HAR (high aspect ratio) structures and metal vias run perpendicular to the layers. The angle between metal lines in different layers is either 0° or 90°. On the other hand, for 3D NAND type structures it is known that their cross-sections are circular on average.

A semiconductor wafer can have a diameter of 300 mm and includes a plurality of several sites, so called dies, each comprising at least one integrated circuit pattern such as for example for a memory chip or for a processor chip. During fabrication, semiconductor wafers run through about 1000 process steps, and within the semiconductor wafer, about 100 and more parallel layers are formed, comprising the transistor layers, the layers of the middle of the line, and the interconnect layers and, in memory devices, a plurality of 3D arrays of memory cells. Dimensions, shapes and placements of the semiconductor structures and patterns are subject to several influences. In manufacturing of 3D-Memory devices, the critical processes are currently etching and deposition. Other involved process steps such as the lithography exposure or implantation also have an impact on the properties of the IC-elements.

With the increasing requirement to the resolution of charged particle imaging systems in three dimensions, the inspection and 3D analysis of integrated semiconductor circuits in wafers becomes more and more challenging. The lateral measurement resolution of charged particle systems is typically limited by the charged particle beam diameter, sampling raster must be adapted accordingly. The sampling raster resolution can be set within the imaging system and can be adapted to the charged particle beam diameter on the sample. The typical raster resolution is 2nm or below, but the raster resolution limit can be reduced with no physical limitation. The charged particle beam diameter has a limited dimension, which depends on the charged particle beam operation conditions and lens. The beam resolution is limited by approximately half of the beam diameter. The resolution can be below 2nm, for example even below 1nm.

A common way to generate 3D tomographic data from semiconductor samples on nm scale is the so-called slice and image approach elaborated for example by a dual beam device (DBD) in which one beam is a focused ion beam (FIB) milling a top surface of a semiconductor sample in order to obtain a wedge . According to several inspection tasks, it is not required to obtain a full 3D volume image. The task of the inspection is to determine a set of specific parameters of semiconductor objects.

The focused ion beam, FIB, technology has many benefits when investigating the semiconductor processing. However, one persistent challenge in FIB applications is the curtaining effect which hinders precision milling and material removal processes.

The curtaining effect is a phenomenon observed during the milling process in which the ion beam, typically composed of Gallium ions interacts with the target material and causes uneven material removal. This results in a nonuniform removal rate across the milled surface leading to irregularities, grooves, and variations in depth. The term curtaining is used in this context to describe the appearance of a material accumulation at the edges of the milled region resembling the folds of a curtain. Accordingly, the different milled materials embedded in the surface have different mill yields which is even crystal grain orientation specific, such as Cu in a $SiO_2$ matrix. The effect expresses as streaks in direction of the milling which give the above-described curtain effect.

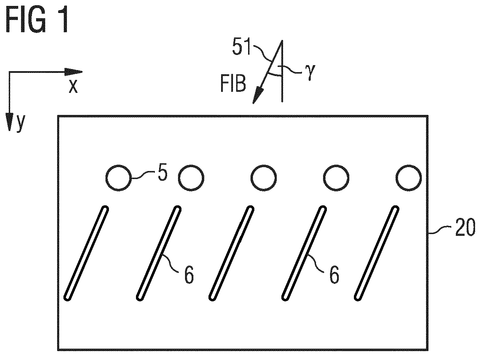

The same effect also occurs for hollow structures such as empty channels in a matrix here, however with an opposite sign. Fig. 1 shows a schematic sketch of the curtaining effect wherein a focused ion beam 51 is directed to a semiconductor sample 20 having a low mill yield material 5, whereas the rest is material having a higher mill yield. In view of the material 5 elevated regions resembling streaks 6 of the higher mill yield material will occur which are protected by the low mill yield material. Accordingly, the curtaining effect is particularly pronounced when milling materials with different physical properties or crystal structures. This limits the range of materials that can be effectively processed using FIB without encountering the curtaining issue. Various strategies have been used to mitigate the curtaining effect such as the adjustment of the rotation angle such that the average mill yield along the ion beam is independent of the x-axis shown in Fig 1. By way of example milling along symmetry axis of the milled service should be avoided. Furthermore, it is possible to reduce the beam current or to introduce reactive gases to equalize the mill yields or to periodically rotate or swing the stage to modify the rotation angle but maintaining the milled plane. A rocking stage is the most versatile solution of the curtaining problem. However, the requirement of navigating to an arbitrary site and adjusting the rotation angle of the plane to the sample surface with a free selection of the rotation angle of the sample itself while maintaining the mill angle when sweeping through different rotating angles of the sample makes the rocking stage a masterpiece of mechanics. Therefore, it is very expensive, requires free space in the instrument and the effort raises even more for doing this for larger semiconductor samples such as a 300 mm wafer.

Accordingly, a need exists to overcome the problems discussed above and to reduce the curtaining effect without the need for a complicated 3D orientation adjustment of the semiconductor sample itself.

Dual beam systems having a focused ion beam and a scanning electron microscopy (SEM) beam normally have for mechanical stability a fixed inclination angle between the ion beam and the SEM column such as 54° for the crossbeam, 65° for the 300 mm wafer or 90° for an L-Shape like arrangement.

While changing of the mill angle is possible for the crossbeam and an L-Shape by tilting the stage, the system for larger wafers such as a 300 mm system doesn't have this degree of freedom and one has to stick with a fixed mill angle $\alpha$. But even for systems with tiltable support for the semiconductor sample like the crossbeam and L-shape there are situations where the stage tilting is not desirable, by way of example in a tomography with sizes in the order of 100-1000 slices where the stage should be tilted back and forth for every mill image cycle with a throughput reduction and mechanical tolerances. Accordingly, a further need exists to be able to change the mill angle in situations such as to see another angle cross-section of the sample, to increase the milling performance versus the curtaining effect and on order to obtain better SEM images from different views of structures such as cavities in the sample.

SUMMARY

This need is met by the features of the independent claims. Further aspects are described in the dependent claims.

According to a first aspect of the invention a method is provided for operating an ion beam device wherein the method comprises the step of determining an incidence or FIB angle $\alpha$ at which a (zero deflection) ion beam of the ion beam device hits an upper top surface of a semiconductor sample. Furthermore, a rotation angle $\gamma$, is determined for the semiconductor sample around a rotation axis A which extends perpendicular to the upper top (sample) surface wherein this axis A extends through a cutting edge where the ion beam hits the upper top surface and wherein the cutting edge defines an edge where a milled surface plane extending oblique to the upper top surface into the semiconductor sample intersects the upper top surface. The semiconductor sample is then rotated around the axis A with the determined rotation angle $\gamma$, and a scan angle $\theta$ is determined between an adapted scan line along which the ion beam is moved when hitting the upper top surface and a default scan line of the ion beam extending parallel to the upper top surface of the semiconductor sample. The scan angle $\theta$ is determined based on the determined rotation angle $\gamma$, and the incidence angle $\alpha$. Furthermore, the scan line is adapted to the amended scan line based on the determined scan angle $\theta$.

With the rotation of the semiconductor sample around the axis A perpendicular to the top surface of the sample the mill direction will be changed, but also the milled plane changes by the rotation. However, this can be compensated by the rotation of the ion beam moving along the scan line with the determined the scan angle.

Furthermore, the corresponding ion beam device is provided comprising a beam generating unit configured to generate the ion beam and comprising at least one control unit configured to control the ion beam and the orientation of the semiconductor sample wherein the control unit is configured to operate according to a method as discussed above or as discussed in further detail below.

According to a further aspect of the invention a method for operating an ion beam device is provided wherein the method comprises the determination of an incidence angle $\alpha$ at which an ion beam of the ion beam device hits the upper top surface of the semiconductor sample. Furthermore, a desired mill angle $\alpha'$ between a milled top surface plane extending oblique to the upper top surface and the upper top surface wherein the milled surface plane is generated by the ion beam. Furthermore, the scan angle $\theta$ between an adapted scan line along which the ion beam is moved when hitting the upper top surface and the default scan line of the ion beam extending parallel to the upper top surface of the semiconductor sample. The scan angle $\theta$ is then determined based on the incidence angle $\alpha$ and the desired mill angle $\alpha'$. Additionally, the scan line of the ion beam is adapted to the amended scan line.

According to this second aspect the change of the mill angle $\alpha'$ without changing the mechanical arrangement can be achieved by using the scan rotation with an adapted scan line. By tilting the ion beam scan along another axis different from the axis parallel to the surface of the semiconductor sample the mill plane rotates around the ion beam axis. Accordingly, here the change of the milling angle is desired especially the angle $\alpha'$ between the milled plane and the upper top surface. This desired angle $\alpha'$ is then up obtained by using the corresponding and appropriate scan angle $\theta$ which can

be determined when the incidence angle $\alpha$ and the desired mill angle $\alpha'$ is known.

Furthermore, the corresponding ion beam device is provided operating as discussed above or as discussed in further detail below.

It is to be understood that the features mentioned above and those yet to be explained below may be used not only in the respective combinations indicated, but also in other combinations or in isolation without departing from the scope of the present disclosure.

BRIEF DESCRIPTION OF THE DRAWINGS

Other features and advantages will be or will become apparent to one with skill in the art upon examination of the following detailed description when read in conjunction with the accompanying drawings in which like-reference numerals refer to like elements.

Fig.1 shows a schematic view of the occurrence of a curtaining effect.

Fig. 2 shows a schematic view of a dual beam system including the ion beam device incorporating features of the invention.

Fig. 3 shows an example view of a geometry showing a relationship between the incidence angle $\alpha$, the scan angle and the mill angle $\alpha'$ of the milled surface.

Fig. 4 shows a schematic view of the milled surface in the surface plane of the sample.

Fig .5A and 5B show a schematic view of how a rotation of the wafer around an axis perpendicular to the surface changes the obtained milled plane.

Fig. 6 schematically shows how a variation of the desired $\alpha'$ with the rotation of the sample depends on the cutting accuracy.

Fig. 7A and 7B schematically show the milled plane so in case of a symmetric stage rocking or rotation around axis A.

Fig. 8 schematically shows the overall milled surface.

Fig. 9 shows a schematic view of the geometry used to determine the different angles in a situation of an adapted scan angle $\theta$.

Fig. 10 shows a schematic view of the relationship between a sample surface plane and the mill plane.

Fig. 11 shows a top view of the geometry of Fig. 10.

Fig: 12 shows a schematical view of a relationship between a scan axis, an adapted scan angle and structures on the sample.

Fig. 13 shows a more detailed view of the situation shown in Fig. 12

DETAILED DESCRIPTION

In the following, embodiments of the disclosure will be described in detail with reference to the accompanying drawings. It is to be understood that the following description of embodiments is not to be taken in a limiting sense. The scope of the disclosure is not intended to be limited by the embodiments described hereinafter or by the drawings, which are taken to be illustrative only.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

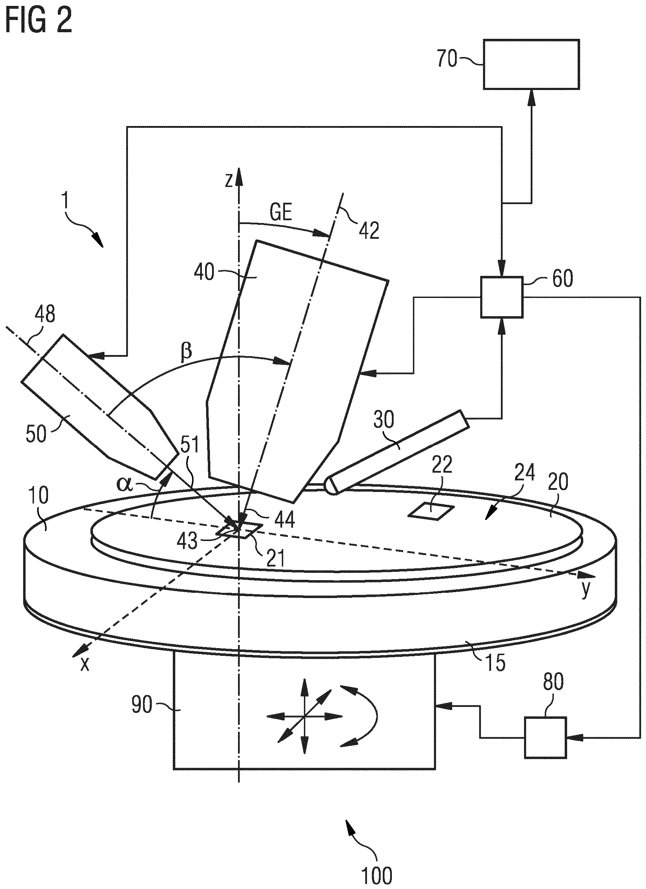

With reference to Fig. 2 a system is shown with which a structure of a semiconductor sample 20 can be examined.

The inspection system 100 is configured for a slice and imaging method under wedge cut geometry with a dual beam device 1. For a wafer 20, several measurement sites, comprising measurement sites 21 and 22 are defined in a location map or inspection list generated from an inspection tool or from design information. The wafer 20 is placed on a wafer support table 10. The wafer support table 10 is mounted on a stage 90 with actuators and position control. Actuators and means for precision control for a wafer stage such as Laser interferometers are known in the art. A control unit 80 configured to control the wafer stage 90 and to adjust a measurement site 21 of the wafer 20 at the intersection point 43 of the dual-beam device 1. The dual beam device 1 is comprising a FIB generating unit 50 with a FIB optical axis 48 and a charged particle beam (CPB) imaging system 40 with optical axis 42. At the intersection point 43 of both optical axes of FIB and CPB imaging system, the wafer surface is arranged at a slant angle a to the FIB axis 48. FIB axis 48 and CPB imaging system axis 42 include an angle beta, and the CPB imaging system axis forms an angle GE with normal to the wafer surface 55. In the coordinate system of figure 1, the normal to the wafer surface 24 is given by the z-axis. The focused ion beam (FIB) 51 is generated by the FIB-generating unit 50 and is impinging under angle alpha on the surface 55 of the wafer 20. Slanted cross-section surfaces are milled into the wafer by ion beam milling at the inspection or measurement site 21 under approximately the slant or mill angle alpha' ($\alpha$'), In the example of figure 2, the incidence angle alpha ($\alpha$) is approximately 30°. With the charged particle beam imaging system 40, inclined under angle $\alpha$ to the wafer normal, images of the milled surfaces could be acquired. In the example of Figure 2, the angle GE is about 15°. However, other arrangements are possible as well, for example with GE = alpha, such that the CPB imaging system axis 42 is perpendicular to the FIB axis 48, or GE = 0°, such that the CPB imaging system axis 42 is perpendicular to the wafer surface 55.

During imaging, a beam 44 of charged particles is scanned by a scanning unit of the charged particle beam imaging system 40 along a scan path over a cross-section surface of the wafer at measurement site 21, and secondary particles as well as scattered particles are generated. Particle detector 30 collects at least some of the secondary particles and scattered particles and communicates the particle count with a control unit 60. Other detectors for other kinds of interaction products may be present as well. Control unit 60 is in control of the charged particle beam imaging system 40, of FIB generating unit 50 and connected to a further control unit 80 to control the position of the wafer mounted on the wafer support table via the wafer stage 90. Control unit 60 communicates with operation control unit 70, which triggers placement and alignment for example of measurement site 21 of the wafer 20 at the intersection point 43 via wafer stage movement and triggers repeatedly operations of FIB milling, image acquisition and stage movements.

Each new intersection surface is milled by the FIB beam 51 and could be imaged by the charged particle imaging beam 44, which is for example scanning electron beam or a Helium-Ion-beam of a Helium ion microscope (HIM).

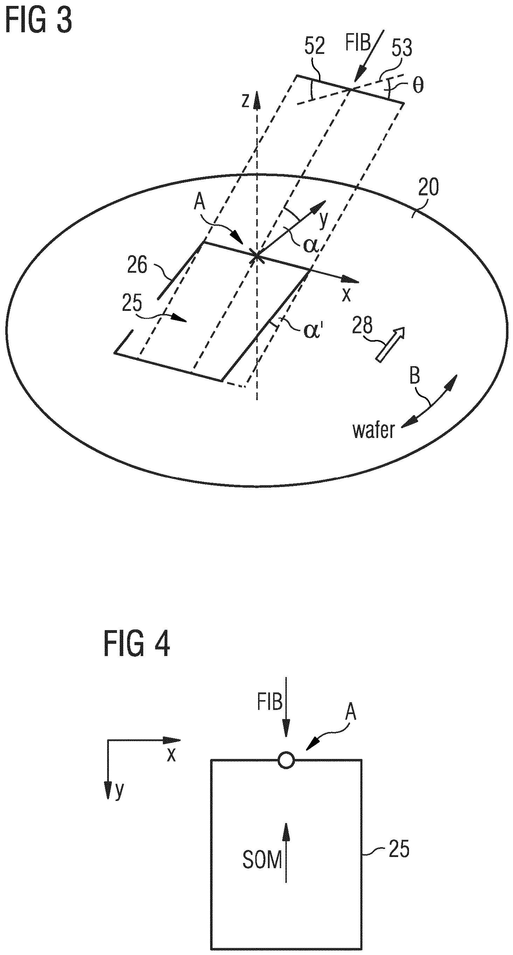

In the following a first solution will be discussed in more detail in which the rocking stage functionality, meaning the rotation of the semiconductor sample 20 around the axis Z of Fig. 2 is used in connection with a rotation of the scan line of the ion beam 51. This will be discussed in more detail in connection with Fig. 3.

As shown in Fig. 3 the substrate semiconductor sample 20 is located in the xy plane and the ion beam, the FIB axis forms an angle $\alpha$ with the surface of the wafer 20 which should be milled at position A as shown and under normal circumstances a scan line 52 is used which is extending parallel to the top surface of the sample 20. Referring to Fig. 3 this means that the angle $\theta$ is zero. In the situation shown the scan line is parallel to the x-axis and the milling occurs in direction of the y-axis. With the rotation angle of $\theta$ being 0 the mill angle $\alpha$' corresponds to the incidence angle $\alpha$ which indicates the angle between the milled surface 25 and the top surface of the sample here indicated by reference numeral 26. Furthermore, the sample orientation mark, SOM 28 is shown representing the rotation around the z axis.

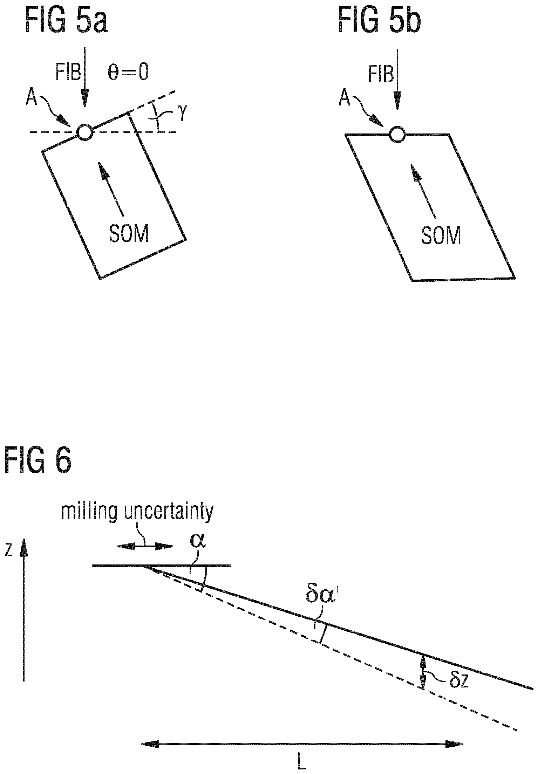

Fig. 4 shows the top-down view with the milled surface 25 when seen in the direction of the z-axis. The scan line of the ion beam can now be changed by the angle $\theta$ resulting in an adapted scan line 53 which has the angle $\theta$ relative to the default or initial scan line parallel to the x-axis in Fig 3. When the sample 20 is now rotated around A parallel to the z-axis as symbolized by arrow B of Fig. 3 with a rotating angle $\gamma$, the mill direction changes but also the milled plane changes as shown in Figures 5A and 5B. Fig. 5A shows the situation when the scan angle is not amended so that $\theta$ is zero and the sample is rotated by the rotation angle $\gamma$, as indicated. Then the intersection of the milled plane with the wafer surface is not anymore along the x axis. This change of the milled plane can be compensated by the rotation of the scan angle, the scan rotation $\theta$ using the following equation:

$$\tan \theta = \tan \gamma \sin \alpha \qquad\qquad (1)$$

wherein $\alpha$ is the angle of the ion beam formed with the top surface plane or xy-plane of the sample 20 as shown in Fig. 3.

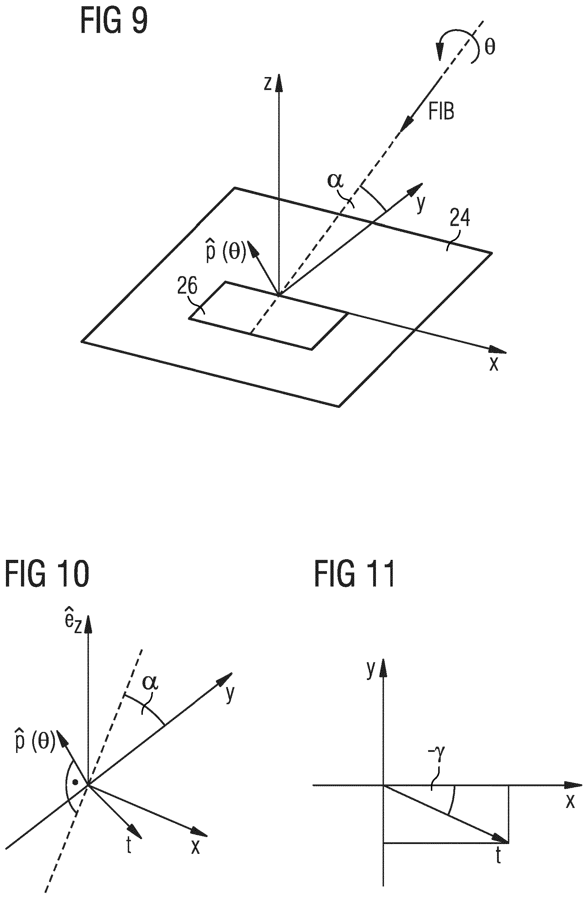

Further details regarding equation 1 will be explained in connection with Figures 9-11 further below when the ion beam scan angle $\theta$ is not 0, the effective angle of the milled plane also changes from $\alpha$ to $\alpha$'($\theta$).

This problem of changing the mill direction to reduce the curtaining can be solved in two ways, namely with the use of

    a) a small angle rocking

b) a symmetric rocking

Each of the solutions a) and b) can be applied alone, however both solutions may also be applied at the same time.

In the following the first solution of the small angle rocking will be explained in more detail. The idea of small angle rocking is to keep the variation $\delta\alpha'$ of $\alpha'$ below an acceptance limit delimiting the rocking amplitude $\delta\gamma$ applied around some mean sample rotation angle $\gamma$ as seen in Fig 1.

In connection with Fig. 9-11 the situation is explained in more detail. Figure 9 shows the FIB or incidence angle $\alpha$, the scan angle $\theta$ and the normal of the milled surface, the normal $\hat{p}(\theta)$ which defines the orientation of the milled surface as the surface can be described by its normal. Without the rotation of the scan angle, $\theta$ is zero, $\hat{p}(\theta)$ is described as follows:

$$\hat{p}(\theta = 0) = \begin{pmatrix} 0 \\ -\sin\alpha \\ \cos\alpha \end{pmatrix} \qquad (2)$$

With scan rotation the situation is as follows:

$$\hat{p}(\theta) = \begin{pmatrix} 1 & 0 & 0 \\ 0 & \cos\alpha & -\sin\alpha \\ 0 & \sin\alpha & \cos\alpha \end{pmatrix} * \begin{pmatrix} -\sin\theta \\ 0 \\ \cos\theta \end{pmatrix} = \begin{pmatrix} -\sin\theta \\ -\sin\alpha\,\cos\theta \\ \cos\alpha\,\cos\theta \end{pmatrix} \qquad (3)$$

The milled angle $\alpha'$ against the sample surface z = 0 is:

$$\cos\alpha' = \hat{e}_z \cdot \hat{p}(\theta) = \cos\theta\,\cos\alpha \qquad (4)$$

In connection with Fig. 10 and 11 the intersection between the sample surface plane and the milled plane is discussed. As shown in Fig. 10 the intersection between the sample surface with normal $\hat{e}_z$ and the milled plane with normal $\hat{p}(\theta)$ runs into the direction $\underline{t}$ which is calculated as follows:

$$\underline{t} = \hat{e}_z \times \hat{p}(\theta) = \begin{pmatrix} 0 \\ 0 \\ 1 \end{pmatrix} \times \begin{pmatrix} -\sin\theta \\ -\sin\alpha\,\cos\theta \\ \cos\alpha\,\cos\theta \end{pmatrix} = \begin{pmatrix} \sin\alpha\,\cos\theta \\ -\sin\theta \\ 0 \end{pmatrix} \qquad (5)$$

The vector $\underline{t}$ lies within the surface plane z=0 i.e., within the xy plane. From Fig. 11 the relationship between the rotation angle $\gamma$, the scan angle $\theta$ and the incidence angle $\alpha$ can be seen. Accordingly, from Eq. 5 in Fig. 11 the following relationship is:

$$\tan(-\gamma) = -\tan(\gamma) = \frac{t_y}{t_x} = \frac{-\sin\theta}{\sin\alpha\,\cos\theta}$$

$$\tan\gamma = \frac{\tan\theta}{\sin\alpha} \qquad (6)$$

Accordingly, Eq. 6 describes the required sample rotation angle to have the cut intersection of the sample surface z=0 with the milled plane along the original sample x-axis shown in Fig. 3. Summarizing the rotation of the scan axis versus the sample rotation is described by the following Eq. 7

$$\sin\alpha\,\tan\gamma = \tan\theta \qquad (7)$$

The milled wedge or mill angle $\alpha'$ describing the angle between the top surface and the milled surface is as follows:

$$\cos\alpha' = \cos\theta\cos\alpha \qquad (8)$$

and the mill angle versus the rotation angle $\gamma$, can be described as follows:

$$\cos\alpha' = \frac{\cos\alpha}{\sqrt{1+sin^2\alpha*tan^2\gamma}} \qquad (9)$$

Referring back to the small angle rocking described under a) above Eq. 9 can be used to calculate the variation of $\delta\alpha'$ when the rotation angle $\gamma$ is changed by $\delta\gamma$ which can be found by solving the equation

$$\cos(\alpha' + \delta\alpha') = \frac{\cos\alpha}{\sqrt{1 + sin^2\alpha * tan^2(\gamma + \delta\gamma)}}$$

for $\delta\alpha'$ with given $\alpha'$, $\alpha$, $\delta\gamma$ and $\gamma$. Furthermore, the acceptable variation $\delta\alpha'$ with $\delta\gamma$, depends on the cutting accuracy which leads a depth uncertainty $\delta z$ as shown in Fig. 6. A certain milling uncertainty leads to a certain depth uncertainty $\delta z$ as shown in Fig. 6 and the length L of the desired wedge. :

The further solution is the use of the second aspect b) described above, the symmetric rocking. From Eq. 9 above it is clear that

$$\alpha'(\gamma) = \alpha'(-\gamma) \qquad (10)$$

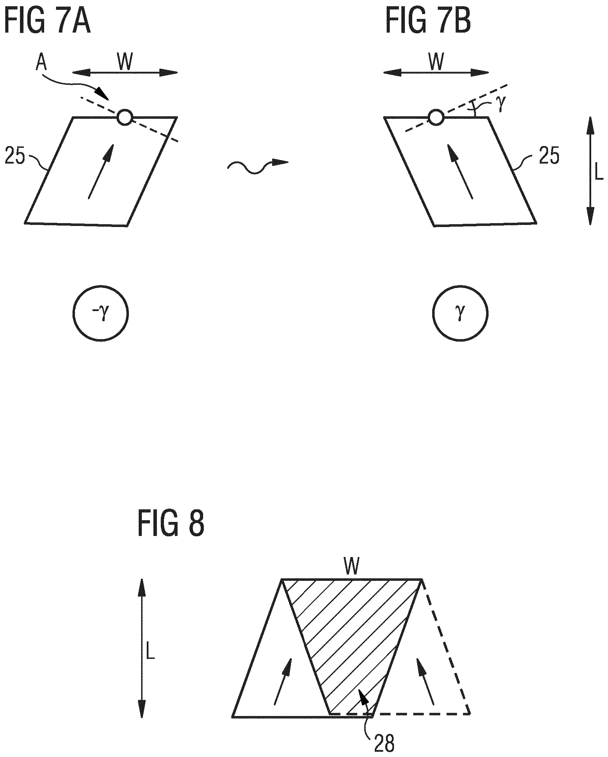

Accordingly, a rocking alternating between $+\gamma$ and $-\gamma$ will mill a wedge with an angle $\alpha'$ as shown by Fig. 7B. Fig. 7A indicates the milled surface 25 for $-\gamma$ whereas Fig. 7B shows the corresponding milled surface 25 for the sample rotation $+\gamma$.

Fig. 8 shows the overall milled width W and the rocking milled region 28 which should be selected large enough for sufficient overlap over L. The symmetric rocking can be combined with the small angle rotation by applying $\delta\gamma$ to both $-\gamma$ and $+\gamma$.

In the following a second basic aspect will be described, namely how the variation of the scan angle can be used to obtain a desired mill angle $\alpha'$. As discussed in the introductory part different reasons exist why a change of the mill angle $\alpha'$ to a value other than the FIB incidence angle $\alpha$ may be desirable.

The change of the milling angle $\alpha'$ without changing the mechanical arrangement can be achieved by using the scan rotation by changing the scan angle $\theta$.

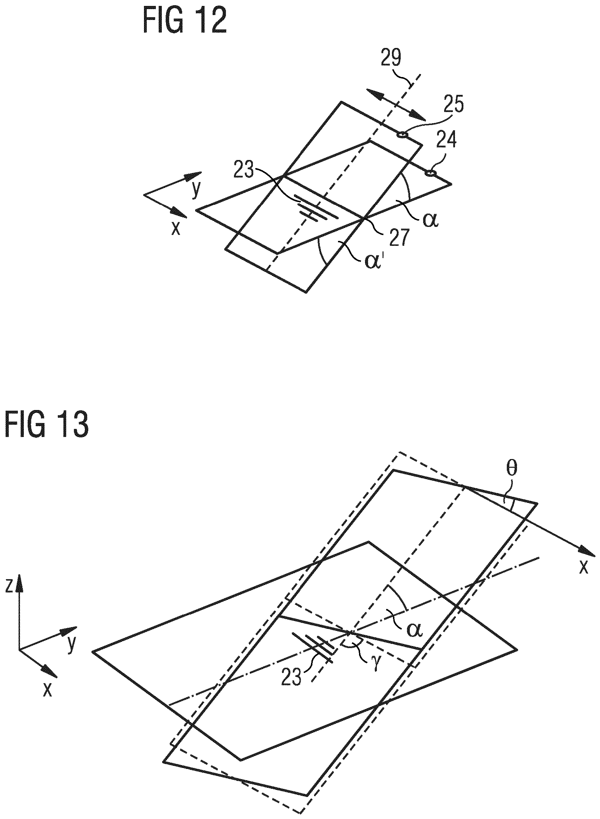

Fig. 12 shows the relationship when the ion beam axis scans along the x-direction 29 describes the ion beam axis and the milled surface 25 relative to the sample surface 24. This leads to a sample and mill plane intersection 27. Furthermore, Fig. 12 shows further structures 23 on the sample. Without the ion beam scan rotation, the ion beam scans along the x-axis and mills a plane with angle $\alpha'=\alpha$ into the sample. By letting the scan along another axis different from x the milled plane rotates around the FIB axis 29.

This is reflected by Fig. 13 and when the scan plane is rotated by angle $\theta$ the mill plane angle changes from $\alpha$ to $\alpha'$ as can be seen by measuring the mill plane surface normal against the z-axis. As a further effect the angle of the structures such as structure 23 on the surface against the intersection between the sample surface and the mill plane changes by $-\gamma$. This can be balanced by rotating the sample around the z-axis by the angle of $\gamma$.

This effect might even be desired for improved curtaining properties. When the sample is rotated around $\gamma$ it is possible to compensate the non-parallel occurrence of the structures 23 to the intersection by the scan rotating $\theta$ and by accepting the change of the wedge angle from $\alpha$ to $\alpha'$. According to the invention the change of $\alpha'$ is desired and other properties can be adjusted accordingly. The mathematics and formulas linking $\alpha$ to $\alpha'$ $\theta$ and $\gamma$ were discussed above in connection with Figures 9 and 10 and equations 2-9.

From the above said some general conclusions can be drawn:

when the scan angle is determined depending on the rotation angle $\gamma$ and the FIB incidence angle $\alpha$ the scan angle may be determined based on the equation:

$$\tan\theta = \tan\gamma\sin\alpha \ .$$

The ion beam may be applied to the upper top surface when the semiconductor sample was rotated by a rotation angle $+\gamma$ and when the sample was rotated by a rotation angle of $-\gamma$, for each of the rotation angles the scan angle $\theta$ can be determined and the scan line can be adapted for each of the rotation angles as determined.

The ion beam can be applied alternately with the adapted scan line when the rotation angle is $\pm\gamma$.

The milled surface extending oblique to the upper top surface generated by the ion beam in the upper top surface can have a mill angle $\alpha'$ with the top surface which changes with the scan angle $\theta$. Here a maximum value of the angle $\alpha$ to $\alpha'$ for the milled top surface not to be exceeded during milling can be determined based on the rotation angle $\gamma$ and the incidence angle $\alpha$.

The angle $\alpha'$ may be determined using Eq. 9 discussed above.

According to the second aspect when the incidence angle $\alpha$ and the desired mill angle $\alpha'$ are known it is possible to determine the scan angle $\theta$ based on the incidence angle $\alpha$ and the desired mill angle $\alpha'$.

Here it is possible to rotate the semiconductor sample around the rotation axis extending perpendicular to the upper top surface with a rotation angle $\gamma$ in order to compensate a scan angle $\theta \neq 0$ wherein the rotating axis extends through a cutting edge where the ion beam hits the upper top surface and the cutting edge defines an edge where milled surface plane hits the upper top surface and the rotation angle $\gamma$ is determined based on the scan angle $\theta$ and the incidence angle $\alpha$.

It is possible to determine the rotation angle based on the following equation:

$$\tan \gamma = \frac{\tan \theta}{\sin \alpha}$$

## Claims

1. A method for operating an ion beam device, the method comprising:

    - determining an incidence angle $\alpha$ at which an ion beam of the ion beam device hits an upper top surface of a semiconductor sample (20),
    - determining a rotation angle $\gamma$ for the semiconductor sample (20) around a rotation axis extending perpendicular to the upper top surface (24), the rotation axis extending through a cutting edge where the ion beam hits the upper top surface, the cutting edge defining an edge where a milled surface plane (25) extending oblique to the upper top surface into the semiconductor sample intersects the upper top surface,
    - rotating the semiconductor sample (20) around the rotation axis with the determined rotation angle $\gamma$,
    - determining a scan angle $\Theta$ between an adapted scan line along which the ion beam is moved when hitting the upper top surface (24), and a default scan line of the ion beam extending parallel to the upper top surface of the semiconductor sample, wherein the scan angle $\Theta$ is determined based on the determined rotation angle $\gamma$ and the incidence angle $\alpha$,
    - adapting the scan line to the amended scan line based on the determined scan angle $\Theta$.

2. The method of claim 1, wherein the scan angle $\Theta$ is determined based on the following equation:

$$\tan \Theta = \tan \gamma \sin \alpha.$$

3. The method of claim 1 or 2, wherein the ion beam is applied to the upper top surface (24) when the semiconductor sample (20) was rotated by a rotation angle +y and a rotation angle -y, and for each of the rotation angles, the scan angle $\Theta$ is determined and the scan line is adapted or each of the rotation angles as determined.

4. The method of claim 3, wherein the ion beam is applied alternatingly with the adapted scan line when the rotation angle is $+\gamma$ and $-\gamma$.

5. The method of any preceding claim, wherein the milled surface plane extending oblique to the upper top surface generated by the ion beam in the upper top surface has a mil angle $\alpha'$ with the upper top surface (24) which changes with the scan angle $\Theta$, wherein a maximum change of the rotation angle $\gamma$ is determined based on the maximal change of the mill angle $\alpha'$ for the milled surface plane.

6. The method of claim 5, wherein the mill angle $\alpha'$ is determined using the following equation:

$$\cos \alpha' = \frac{\cos \alpha}{\sqrt{1 + \sin^2 \alpha * \tan^2 \gamma}}$$

**7.** A method for operating an ion beam device, the method comprising:

- determining an incidence angle $\alpha$ at which an ion beam of the ion beam device hits an upper top surface of a semiconductor sample,
- determining a desired mill angle $\alpha'$ between a milled surface plane extending oblique to the upper top surface and the upper top surface, wherein the milled surface plane is generated by the ion beam,
- determining a scan angle $\Theta$ between an adapted scan line along which the ion beam is moved when hitting the upper top surface, and a default scan line of the ion beam extending parallel to the upper top surface of the semiconductor sample, wherein the scan angle is determined based on the incidence angle $\alpha$ and the desired mill angle $\alpha'$
- applying the ion beam along the adapted scan line.

**8.** The method of claim 7, wherein the semiconductor sample is rotated around a rotation axis extending perpendicular to the upper top surface with a rotation angle $\gamma$ in order to compensate a scan angle $\Theta$ not equal zero, the rotation axis extending through a cutting edge where the ion beam hits the upper top surface, the cutting edge defining an edge where the milled surface plane intersects the upper top surface, wherein the rotation angle $\gamma$ is determined based on the scan angle $\Theta$ and the incidence angle $\alpha$.

**9.** The method of claim 8, wherein the rotation angle $\gamma$ is determined with the following equation:

$$\tan \gamma = \tan \Theta \, / \, \sin \alpha$$

**10.** An ion beam device comprising

- an ion beam generating unit (50) configured to generate an ion beam for a semiconductor sample provided on a support structure,
- at least one control unit configured to control the ion beam and the orientation of the semiconductor sample, the control unit being configured to

  - determine an incidence angle $\alpha$ at which an ion beam of the ion beam device hits an upper top surface of a semiconductor sample,

  - determine a rotation angel $\gamma$ for the semiconductor sample around a rotation axis extending perpendicular to the upper top surface, the rotation axis extending through a cutting edge where the ion beam hits the upper top surface, the cutting edge defining an edge where a milled surface plane extending oblique to the upper top surface into the semiconductor sample intersects the upper top surface,
  - rotate the semiconductor sample around rotation axis with angle $\gamma$,
  - determine a scan angle $\Theta$ between an adapted scan line along which the ion beam is moved when hitting the upper top surface, and a default scan line of the ion beam extending parallel to the upper top surface of the semiconductor sample, wherein the scan angle $\Theta$ is determined based on the determined rotation angle $\gamma$ and the incidence angle $\alpha$
  - adapt the scan line to the amended scan line based on the determined scan angle $\Theta$.

**11.** The ion beam device of claim 10, wherein the control unit is further configured to carry out a method as mentioned in any of claims 2 to 6.

**12.** An ion beam device comprising

- an ion beam generating unit (50) configured to generate an ion beam for a semiconductor sample provided on a support structure,
- at least one control unit configured to control the ion beam and the orientation of the semiconductor sample, the control unit being configured to

  - determine an incidence angle $\alpha$ at which an ion beam of the ion beam device hits an upper top surface of a semiconductor sample,
  - determine a desired mill angle $\alpha'$ between a milled surface plane extending oblique to the upper top surface generated by the ion beam in the upper top surface and the upper top surface,

- determine a scan angle $\Theta$ between an adapted scan line along which the ion beam is moved when hitting the upper top surface, and a default scan line of the ion beam extending parallel to the upper top surface of the semiconductor sample, wherein the scan angle is determined based on the incidence angle $\alpha$ and the desired mill angle $\alpha'$

- apply the ion beam along the adapted scan line.

13. The ion beam device according to claim 12, wherein the control unit is further configured to carry out a method as mentioned in any of claims 8 or 9.

# FIG 1

# FIG 2

FIG 3

FIG 4

# FIG 5a

# FIG 5b

# FIG 6

FIG 7A

FIG 7B

FIG 8

## FIG 9

## FIG 10

## FIG 11

## FIG 12

## FIG 13

**EP 4 531 073 A2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102023126288